# EUROPÄISCHE PATENTSCHRIFT

(11) **EP 2 368 000 B1**
(45) Veröffentlichungstag und Bekanntmachung des Hinweises auf die Patenterteilung: **28.01.2015**
(21) Anmeldenummer: 09799270.5
(22) Anmeldetag: 14.12.2009
(51) Int. Cl.: E05B 81/76, H05K 1/02, H05K 1/14, H05K 3/20, H05K 3/30

(54) **TÜRAUSSENGRIFF, INSBESONDERE FÜR FAHRZEUGE SOWIE VERFAHREN ZU DESSEN HERSTELLUNG**
EXTERIOR DOOR HANDLE, PARTICULARLY FOR VEHICLES, AND METHOD FOR THE PRODUCTION THEREOF
POIGNÉE EXTÉRIEURE DE PORTIÈRE, NOTAMMENT POUR VÉHICULES AUTOMOBILES, ET PROCÉDÉ DE FABRICATION DE CELLE-CI

(30) Priorität: 20.12.2008 DE 102008064339; 19.02.2009 DE 102009009729
(43) Veröffentlichungstag der Anmeldung: 28.09.2011
(73) Patentinhaber: Huf Hülsbeck & Fürst GmbH & Co. KG, 42551 Velbert (DE)
(72) Erfinder: RHEIN, Michael, 41199 Mönchengladbach (DE); GERDES, Bernd, 45355 Essen (DE); VAN THIEL, Simone, 47829 Krefeld (DE); LIPINSKI, Wolfgang, 42549 Velbert (DE); WEIDNER, Jörg, 42389 Wuppertal (DE); GEBER, Michael, 73773 Aichwald (DE); FREYHOLDT, Uwe, 89537 Giengen/Brenz (DE)
(74) Vertreter: Buse, Mentzel, Ludewig Patentanwaltskanzlei
(86) Internationale Anmeldenummer: PCT/EP2009/009100
(87) Internationale Veröffentlichungsnummer: WO 2010/069579

(56) Entgegenhaltungen:
- EP-A2- 1 840 845
- DE-A1- 10 204 025
- DE-A1-102004 026 442

## Beschreibung

Die Erfindung betrifft einen Türaußengriff insbesondere für Fahrzeuge nach den Merkmalen des Oberbegriffes von Anspruch 1 sowie ein Verfahren zu dessen Herstellung nach Anspruch 17. Solche Türaußengriffe finden in modernen Fahrzeugen häufig Verwendung. Im Inneren der Handhabe können elektronische Bauteile vorgesehen sein, die beispielsweise die Zugangsberechtigung zum Fahrzeug steuern oder auch andere Funktionen und Aufgaben ausführen. Die elektronischen Bauteile werden hierbei meist auf einer Leiterplatte angeordnet.

Da die verschiedenen Fahrzeugtypen auch unterschiedliche Handhaben für die Türaußengriffe aufweisen, müssen auch die elektronischen Bauteile bzw. die Leiterplatte an die Form der Handhabe angepasst werden. Ist bei der Elektronik der Handhabe ein Hallsensor vorgesehen, beispielsweise um eine Bewegung der Handhabe relativ zum Fahrzeug, zur Fahrzeugtür oder zum Grifflager zu detektieren, so muss dieser an einer ganz bestimmten, vordefinierten Stelle angebracht werden. Der Hallsensor besteht dabei meist aus zwei Teilen, nämlich aus dem eigentlichen Sensor und einem Permanentmagneten. Der Einfachheit halber sollen beide als "Hallelement" bezeichnet werden. Um nun die entsprechenden Türaußengriffe für die unterschiedlichsten Fahrzeugtypen bereitzustellen, muss die Leiterplatte auf welcher sich die elektronischen Bauteile befinden, für jeden Türaußengriff individuell angepasst werden. Dies ist sehr aufwendig und kosten- und lagerplatzintensiv. Da die Türaußengriffe aus haptischen und ästhetischen Gründen häufig gebogen ausgeführt werden, muss regelmäßig auch eine gebogene Leiterplatte vorgesehen sein, um das entsprechende Hallelement, an die entsprechende Stelle zu bringen. In diesem Fall werden die Bauteile auf einer Folie montiert, welche wiederum auf einem Trägerbauteil aufgebracht wird. Dieser Trägerbauteil ist dann von seiner Form her der Form des entsprechenden Türaußengriffes angepasst. Dieses Herstellungsverfahren ist deutlich teurer und komplizierter als die Herstellung von herkömmlichen Leiterplatten.

Aufgabe der Erfindung ist es daher, einen Türaußengriff zu schaffen, der einfach und kostengünstig herstellbar ist, sowie darüber hinaus ein Verfahren bereitzustellen, durch welches Türaußengriffe in unterschiedlichsten Ausführungen mit gleichen Elektronikkomponenten einfach und kostengünstig herstellbar sind. Diese wird durch die kennzeichnenden Merkmale des Anspruches 1 sowie durch Anspruch 17 gelöst, denen folgende besondere Bedeutung zukommt.

Die Leiterplatte ist starr und plan ausgebildet. Des Weiteren ist ein separater Halter vorgesehen, der das Hallelement trägt und es hierdurch im Inneren der Handhabe an der gewünschten vordefinierten Position haltert. Diese Position ist von der Leiterplatte beabstandet. Hierdurch ist es möglich, eine starre und plane Leiterplatte auch bei gebogenen Handhaben vorzusehen. Trotzdem ist das Hallelement durch den separaten Halter an der gewünschten vordefinierten Position anbringbar.

Gemäß Anspruch 17 können für verschiedene Typen von Türaußengriffen und somit auch verschiedene Typen von Handhaben identische Leiterplatten vorgesehen sein. Durch die Anpassung des verwendeten Halters kann das Hallelement an quasi jeder gewünschten Stelle angeordnet werden. Hierdurch spart man Produktions- und Lagerkosten, insbesondere für die Leiterplatte und muss nur für die verschiedenen Anwendungen unterschiedliche Halter vorrätig haben.
Besonders vorteilhaft ist es, das Hallelement mit dem Halter vorzumontieren und hierdurch eine Baugruppe zu bilden. Diese Baugruppe kann dann einfacher montiert werden, insbesondere an der Leiterplatte oder auch direkt in der Handhabe.

Häufig kommt es vor, dass das Hallelement elektrische Leiter aufweist. Hier ist es dann besonders vorteilhaft, wenn der Halter Führungen für diesen bzw. diese elektrischen Leiter aufweist. Eine korrekte Positionierung der Leiter und ein Schutz vor Beschädigungen werden hierdurch ermöglicht.

Weitere Ausführungsformen und Vorteile der Erfindung ergeben sich aus den Unteransprüchen, der nachfolgenden Beschreibung und den Zeichnungen. In den Figuren ist die Erfindung in diversen Ausführungsbeispielen dargestellt. Es zeigen:
- Fig. 1: einen erfindungsgemäßen Halter in einer ersten Ausführungsform;
- Fig. 2: ein erfindungsgemäßes Hallelement in einer ersten Ausführungsform;
- Fig. 3: ein erfindungsgemäßes Potentialausgleichselement in einer ersten Ausführungsform;
- Fig. 4a: den Zusammenbau der Elemente der Fig. 1, 2 und 3;
- Fig. 4b: einen Halter, ein Hallelement und ein Potentialausgleichselement im Zusammenbau in einer zweiten Ausführungsform;
- Fig. 5: die Elemente aus Fig. 4a im Zusammenbau mit einer Leiterplatte und mit einem Keil;
- Fig. 6: eine Detailansicht aus Fig. 5;
- Fig. 7a: die Elemente aus Fig. 6 in perspektivischer Ansicht von unten;
- Fig. 7b: die Elemente aus Fig. 4b auf einer Leiterplatte, perspektivisch von unten;
- Fig. 8: ein Hallelement mit zweiteiligem Halter;
- Fig. 9: ein vergrößerter Ausschnitt aus Fig. 8;
- Fig. 10: ein weiteres Ausführungsbeispiel eines erfindungsgemäßen Halters;
- Fig. 11: der Halter aus Fig. 10 mit eingebautem Hallelement vor der Endmontage;
- Fig. 12: Halter und Hallelement aus den Fig. 10 und 11 in zusammengebautem Zustand;
- Fig. 13: ein weiteres Ausführungsbeispiel eines Halters mit Hallelement und Potentialausgleichselement in Explosionsdarstellung;
- Fig. 14: die Elemente aus Fig. 13 in zusammengebautem Zustand;
- Fig. 15: ein Hallelement mit elektrischen Leitern als Stanzgitter in Explosionsdarstellung;
- Fig. 16: die Elemente aus Fig. 15 inclusive Halter;
- Fig. 17: die Baugruppe aus Fig. 16 mit angebrachtem Potentialausgleichselement;
- Fig. 18: ein weiteres Ausführungsbeispiel der Elemente aus Fig. 15;
- Fig. 19: das Ausführungsbeispiel aus Fig. 18 in einer Darstellung gemäß Fig. 16;
- Fig. 20: Baugruppe aus Fig. 19 mit montiertem Potentialausgleichselement;
- Fig. 21: eine letzte Ausführungsform der Erfindung mit Stanzgitter und Hallelement in Explosionsdarstellung;
- Fig. 22: die Elemente aus Fig. 21 mit montiertem Hallelement;
- Fig. 23: die Elemente aus Fig. 22 mit angespritztem Halter;
- Fig. 24: die Elemente aus Fig. 23 auf der Leiterplatte montiert.
- Fig. 25: Keil aus Fig. 5

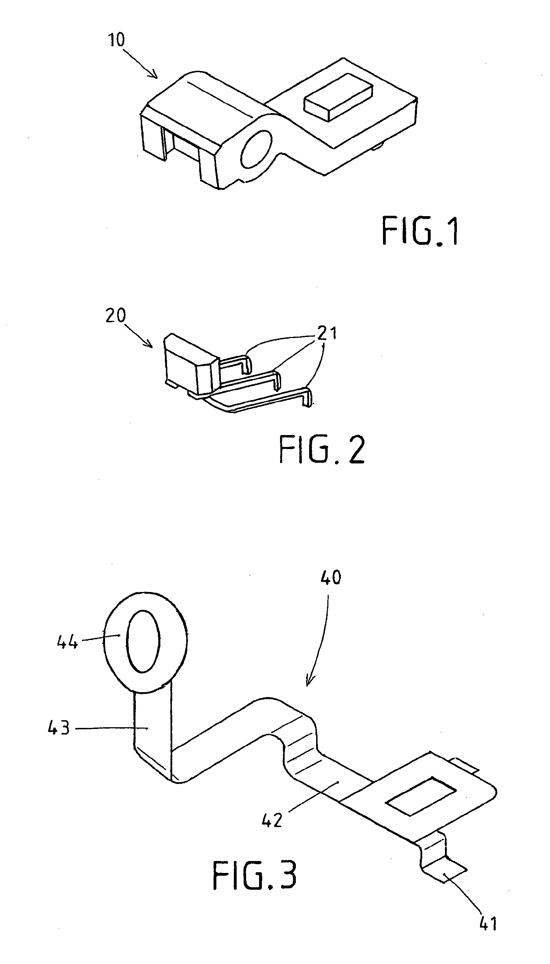

Fig. 1 zeigt einen erfindungsgemäßen Halter 10 für das Hallelement 20 aus Fig. 2. Das Hallelement 20 besteht hier aus dem eigentlichen Hall-Sensor. Selbstverständlich ist es auch möglich als Hallelement einen Permanentmagneten vorzusehen, während der Sensor in einem anderen Bereich des Fahrzeuges, z. B. in der Fahrzeugtür oder im Türaußengriff befindlich ist. Das Hallelement 20 verfügt hier über elektrische Leiter 21.

In diesem Ausführungsbeispiel ist auch noch ein Potentialausgleichselement 40 vorgesehen. Dieses dient dem Potentialausgleich bei einem metallischen, metallbeschichteten und/oder anders elektrisch leitfähigen Gehäuseelement der Handhabe. Das Potentialausgleichselement 40 besteht im vorliegenden Ausführungsbeispiel aus einem Blech und besitzt an seinem, dem Halter 10 abgewandten einen Ende 43 eine Öse 44, durch welche es mit dem entsprechenden Gehäusebauteil der Handhabe in elektrische Wirkverbindung bringbar ist. Hierzu bieten sich vor allem Niet- oder Schraubverbindungen an.

An seinem dem Halter 10 zugewandten anderen Ende 42 hat das Potentialausgleichselement 40 Vorfixierungsmittel 41, deren nähere Bedeutung noch erklärt werden wird. Des Weiteren besitzt das Potentialausgleichselement 40 an seinem anderen Ende 42 ein Anschlussmittel 45, welches mit einem Gegenanschlussmittel 17 des Halters 10 in Wirkverbindung bringbar ist, um das Potentialausgleichselement 40 am Halter 10 zu montieren.

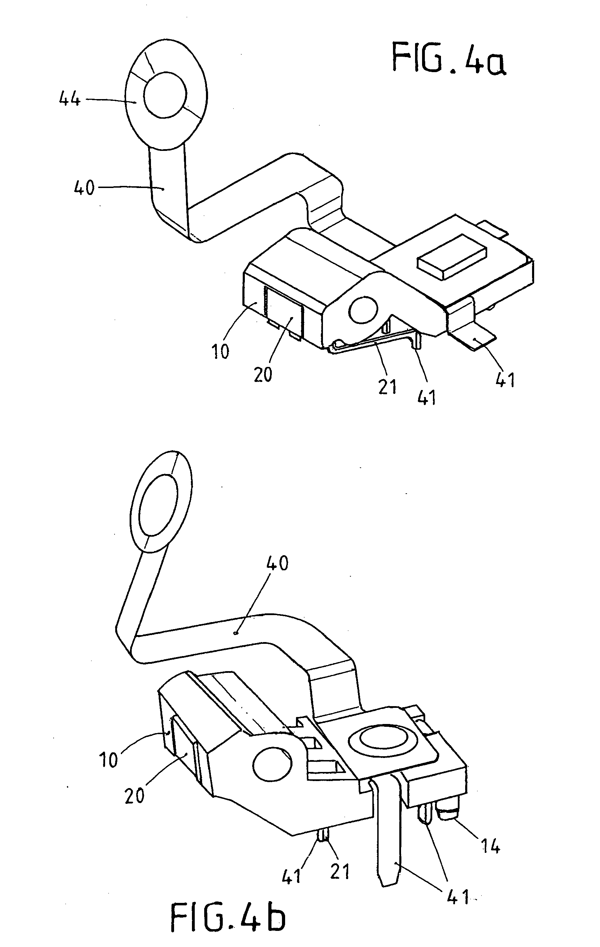

Fig. 4a zeigt nunmehr eine Baugruppe bestehend aus dem Halter 10, dem Hallelement 20, den elektrischen Leitern 21 und dem Potentialausgleichselement 40 aus den Fig. 1 bis 3. Das Hallelement 20 und das Potentialausgleichselement 40 sind mit dem Halter 10 lösbar verbunden und zwar durch Verklemmen bzw. Verklipsen. Selbstverständlich sind auch andere Verbindungsmöglichkeiten denkbar, wie beispielsweise Verklammern, Stecken, Hinterhaken oder auch unlösbare Verbindungsmöglichkeiten wie Verkleben, Verschweißen, Umspritzen oder Vergießen. Hier sind prinzipiell sämtliche Verbindungsmöglichkeiten denkbar.

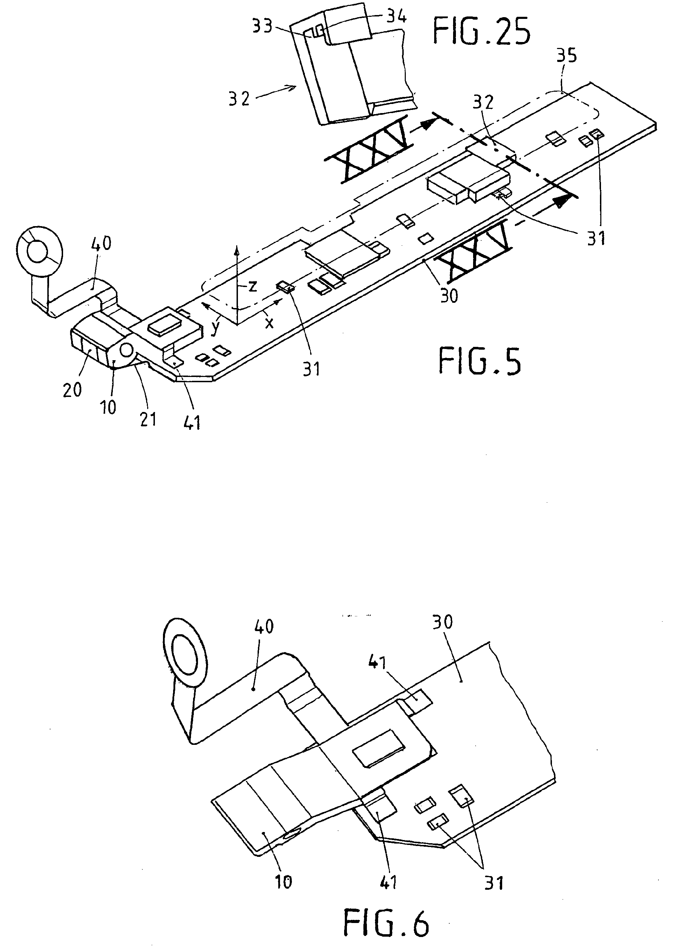

Fig. 5 zeigt nun die Baugruppe aus Fig. 4a auf einer Leiterplatte 30 angebracht. Die Leiterplatte 30 verfügt hierbei über verschiedene elektronische Bauteile 31. Der Halter 10 steht mit der Leiterplatte 30 in Wirkverbindung, wobei auch hier jeweils wieder die unterschiedlichsten Verbindungsmöglichkeiten denkbar sind. Die Verbindung kann dabei lösbar oder auch unlösbar erfolgen. Das Hallelement 20 ist von der Leiterplatte 30 beabstandet angeordnet, um an seine erforderliche Position gebracht zu werden. Zur Veranschaulichung ist in Fig. 5 ein Koordinatensystem dargestellt. Je nach Anwendungsfall muss das Hallelement an einem vordefinierten Punkt angeordnet werden. Dieser Punkt ist zumeist von der Lage der Leiterplatte 30 im Koordinatensystem in x-, y- und/oder z-Richtung abweichend. Diese Distanz wird von dem erfindungsgemäßen Halter 10 überwunden, der als Verbindungsstück zwischen dem Hallelement 20 und der Leiterplatte 30 fungiert.

Des Weiteren steht das Potentialausgleichselement 40 über den Halter 10 mit der Leiterplatte 30 in Wirkverbindung. Besonders vorteilhaft ist es, das Potentialausgleichselement 40 dabei mit dem Massepotential der Leiterplatte 30 zu verbinden, um den Potentialausgleich des elektrisch leitfähigen Gehäusebauteils der Handhabe zu ermöglichen.

Außerdem erkennt man die Vorfixierungsmittel 41 des Potentialausgleichselementes 40, welche dafür sorgen, dass das Potentialausgleichselement 40 an den richtigen Stellen mit der Leiterplatte 30 kontaktiert wird. Grundsätzlich sorgt dafür jedoch auch der Halter 10, der an seiner vorbestimmten Stelle an der Leiterplatte 30 angeordnet wird.

Fig. 5 zeigt darüber hinaus auch den Keil 32, welcher aus Fig. 25 näher erkennbar wird. Der Keil 32 hat dabei mehrere Aufgaben. Er findet insbesondere dann Anwendung, wenn der Türaußengriff eine in etwa U-förmige Grundschale umfasst. Um Gewicht und Materialkosten zu sparen, wird die Grundschale häufig vergleichweise dünnwandig ausgeführt. Dies sowie die gegebenenfalls vorliegenden Fertigkeitstoleranzen können dazu führen, dass die U-Schenkel an ihrem oberen Ende zu dicht zusammen stehen, so dass sie beispielsweise mit einer vorgesehenen Deckschale nicht mehr in Wirkverbindung bringbar sind. Der Keil 32 spreizt im eingebauten Zustand die beiden U-Schenkel der Grundschale, so dass deren Enden den vordefinierten Abstand einhalten. Darüber hinaus hat der Keil 32 noch die Aufgabe die Leiterplatte 30 richtig im Türgriff zu positionieren. Hierzu verfügt der Keil 32 über eine erste Aufnahme 33 für die Leiterplatte 30. Falls neben der Leiterplatte 30 auch eine Elektrode 35, welche hier in Fig. 5 strichpunktiert angedeutet wird, vorgesehen ist, kann der Keil 32 eine zweite Aufnahme 34 für die Elektrode 35 aufweisen. Durch das Positionieren der Leiterplatte 30 mit Hilfe des Keils 32 ist ein sicherer und korrekter Einbau der Leiterplatte 30 im Türgriff gegeben.

Wird die Elektrode 35 mittels der zweiten Aufnahme 34 des Keiles 32 im Türgriff positioniert, ergeben sich dadurch weitere Vorteile. Insbesondere bei der Verwendung einer kapazitiven Elektrode 35 wird so sichergestellt, dass sich diese immer an der gleichen korrekten Position im Türgriff befindet. Ansonsten könnten durch Fertigungs- und Einbautoleranzen unterschiedliche Positionen der Elektrode 35 entstehen, was auch zu unterschiedlichen elektromagnetischen Eigenschaften der Elektrode 35 führt und somit ein gleichbleibendes Sensier- bzw. Auslöseverhalten der Elektronik nicht mehr gegeben wäre.

Besonders vorteilhaft ist es, den Keil 32 auf die Leiterplatte 30 und/oder die Elektrode 35 aufzuclipsen. Dies stellt eine einfache und kostengünstige Form der Montage dar. Sodann wird der Keil 32 einschließlich Leiterplatte 30 bzw. Elektrode 35 in die Grundschale des Türgriffes eingeführt. Üblicherweise wird dann eine Vergussmasse in den Türgriff eingebracht, beispielsweise ein Gießharz oder eine Silikonmasse, um die Fahrzeugelektronik vor Verschmutzungen und Feuchtigkeit zu bewahren. Abschließend kann dann eine obere Griffschale oder ein Deckel auf den Griff aufgesetzt werden.

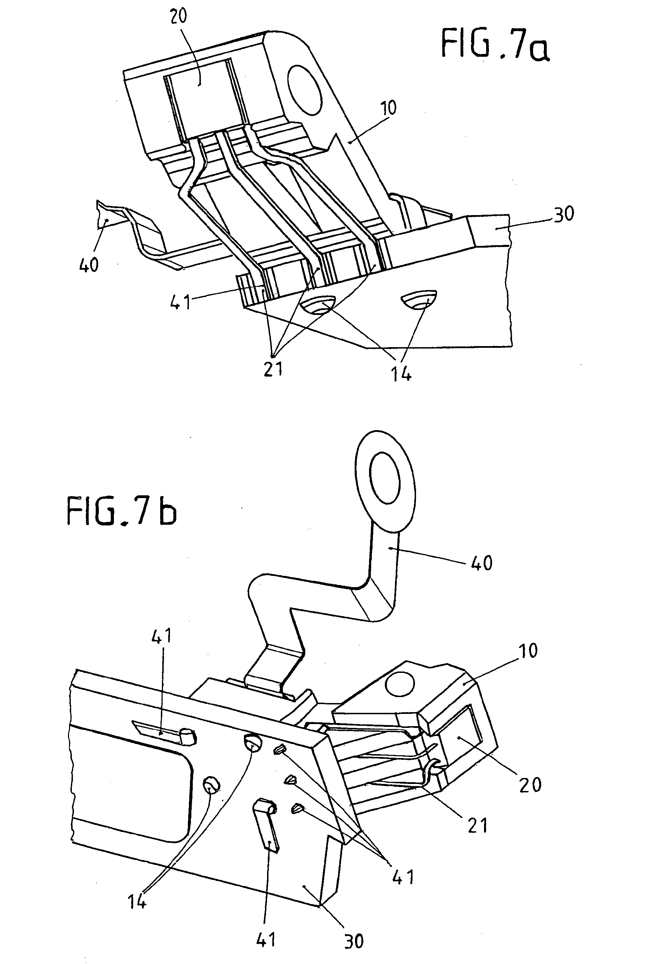

Die Fig. 6 und 7 zeigen nochmals deutlich, wie die Baugruppe bestehend aus Halter 10, Hallelement 20 und Potentialausgleichselement 40 aus den Fig. 1 bis 3 an der Leiterplatte 30 angeordnet sind. Man erkennt hier auch die Positionierungsmittel 14 des Halters 10, sowie die Vorfixierungsmittel 41 der elektrischen Leiter 21 des Hallelementes 20 und des Potentialausgleichselementes 40. Diese Positionierungsmittel 14 und Vorfixierungsmittel 41 dienen dazu, die Baugruppe besonders einfach und schnell an der Leiterplatte 30 anzuordnen. Selbstverständlich ist es auch möglich, die Positionierungsmittel 14 und die Vorfixierungsmittel 41 als ein einziges Bauteil vorzusehen. Die elektrischen Leiter 21 des Hallelementes 20 und das Potentialausgleichselement 40 werden hierbei insbesondere durch das Anordnen des Halters 10 an der Leiterplatte 30 auf der Leiterplatte 30 positioniert. Der Halter 10 wird dabei mittels der Positionierungsmittel 14 an der Leiterplatte 30 verclipst. Es sind selbstverständlich auch andere Methoden von lösbaren oder unlösbaren Verbindungen zwischen der Leiterplatte 30 und dem Halter 10, dem Hallelement 20 oder dessen elektrischen Leitern 21 oder auch dem Potentialausgleichselement 40 denkbar. Die elektrischen Leiter 21 des Hallelementes 20 und oder das Potentialausgleichselement 40 bzw. die Vorfixierungsmittel 41 können dann noch an der Leiterplatte 30 verlötet werden, um eine sichere elektrische Verbindung zu erzeugen.

Die Fig. 4b und 7b zeigen eine Baugruppe gemäß den Fig. 4a und 7a, aber in einem anderen Ausführungsbeispiel. Auch hier werden der Halter 10, das Hallelement 20 und das Potentialausgleichselement 40 zunächst als Baugruppe zusammengefügt und dann an der Leiterplatte 30 montiert. Der Halter 10 verfügt dabei auch wieder über Positionierungsmittel 14, während die elektrischen Leiter 21 des Hallelementes 20 und das Potentialausgleichselement 40 über Vorfixierungsmittel 41 verfügen.

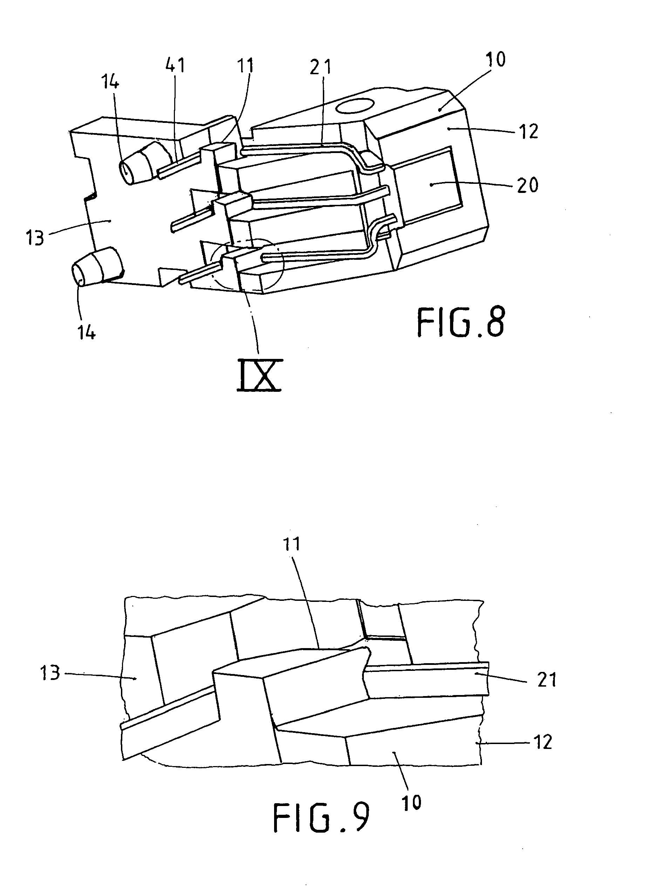

Ein besonders vorteilhaftes Ausführungsbeispiel zeigen die Fig. 8 und 9. Hier ist der Halter 10 zweiteilig ausgebildet. Der erste Teil 12 dient zur Aufnahme des Hallelementes 20. Bei der Montage des zweiten Teiles 13 am ersten Teil 12 werden die elektrischen Leiter 21 des Hallelementes 20 durch Führungen 11 des zweiten Teiles 13 des Halters geführt. So wird eine sichere Montage der elektrischen Leitungen 21 während der Montage des Halters 10 an der Leiterplatte 30 erzielt und Beschädigungen der elektrischen Leiter 21 des Hallelementes 20 vermieden.

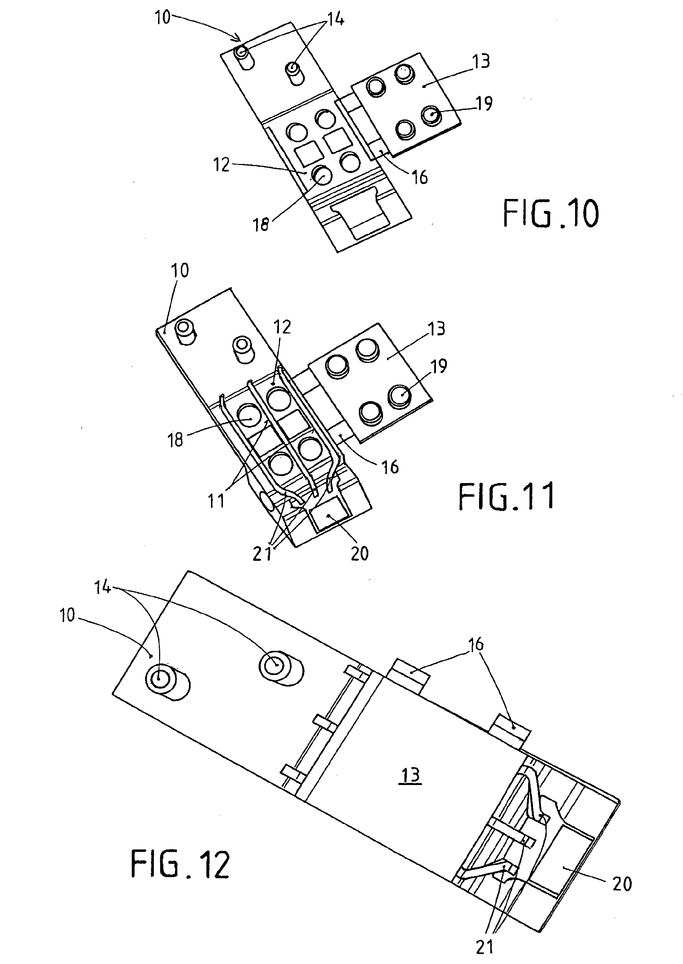

Die Fig. 10 bis 12 zeigen ein weiteres Ausführungsbeispiel der erfindungsgemäßen Vorrichtung. Der Halter 10 ist dabei zweiteilig 12, 13 ausgeführt. Die beiden Teile 12, 13 sind über zwei Filmscharniere 16 miteinander verbunden. Des Weiteren weisen die Teile 12, 13 Ausnehmungen 18 und Vorsprünge 19 auf, durch welche sie mittels einer Rast- bzw. Steckverbindung verbindbar sind. Bei der Montage des Hallelementes 20 werden die zugehörigen elektrischen Leiter 21 direkt in dem ersten Teil 12 des Halters 10 positioniert. Der zweite Teil 13 des Halters 10 wird dann deckelartig über den ersten Teil 12 geklappt und mit diesem zusammengesteckt. Dabei werden die Vorsprünge 19 und die Ausnehmung 18 in Wirkverbindung gebracht. Hieraus entsteht die in Fig. 12 gezeigte Baugruppe. Man erkennt die Positionierungsmittel 14 am Halter 10, die zur Positionierung der Baugruppe an der Leiterplatte 30 dienen. Selbstverständlich können die beiden Teile 12, 13 des Halters 10 auch auf andere Art lösbar oder unlösbar miteinander verbunden werden. Hier sind prinzipiell sämtliche Arten der Befestigung bzw. Verbindung denkbar.

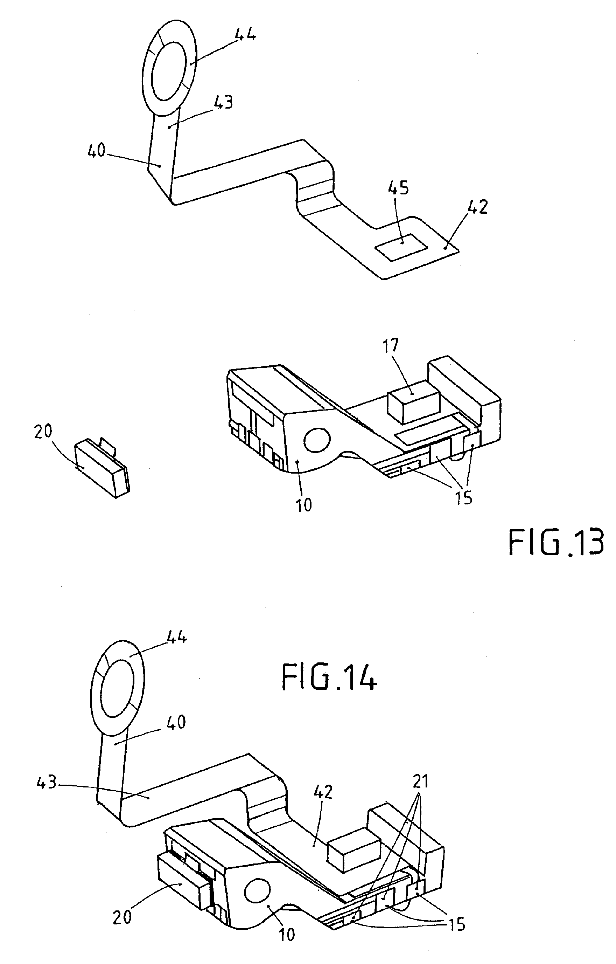

Ein weiteres Ausführungsbeispiel zeigen die Fig. 13 und 14. Hier sind die elektrischen Leiter 21 des Hallelementes 20 direkt am Halter 10 realisiert. Im vorliegenden Ausführungsbeispiel geschieht dies durch leitfähige Bereiche 15 des Halters 10, die vorwiegend aus leitfähigem Kunststoff ausgeführt sind. Selbstverständlich ist es auch denkbar, die elektrischen Leiter 21 im Halter 10 zu integrieren, beispielsweise durch Umspritzen von metallischen Leiterbahnen. Auch die elektrische Kontaktierung des Potentialausgleichselementes 40 erfolgt im vorliegenden Fall über die Halter 10 integrierten leitfähigen Bereiche 15.

Das Potentialausgleichselement 40 ist, wie auch schon in einigen der vorherigen Ausführungsbeispiele, über ein Anschlussmittel 45 mit einem Gegenanschlussmittel 17 am Halter 10 verbunden. Das Anschlussmittel 45 ist dabei am anderen Ende 42 des Potentialausgleichselementes 40 angeordnet. Im vorliegenden Fall liegt zwischen dem Anschlussmittel 45 und dem Gegenanschlussmittel 17 eine Steckverbindung vor. Selbstverständlich sind auch hier andere lösbare oder unlösbare Verbindungen denkbar, wie beispielsweise Verkleben, Verschweißen, Verklipsen, Verrasten oder Ähnliches.

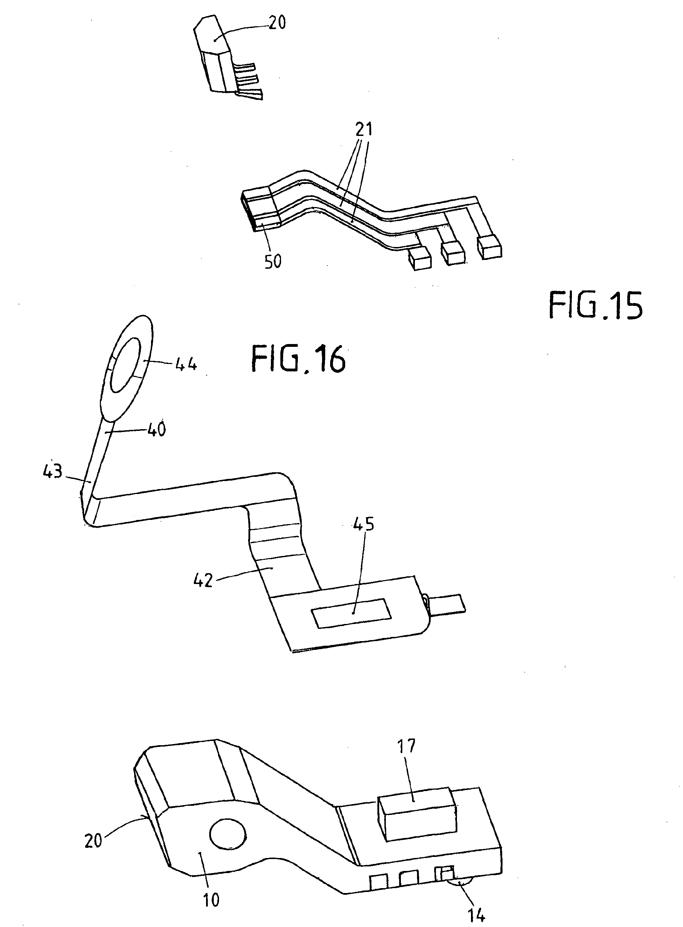

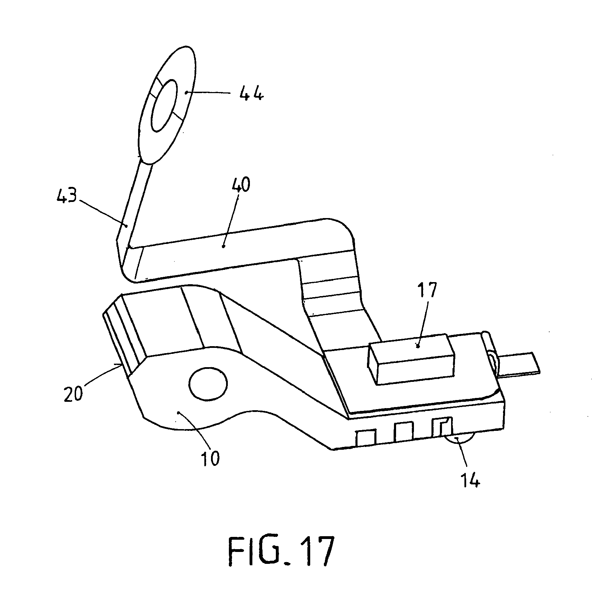

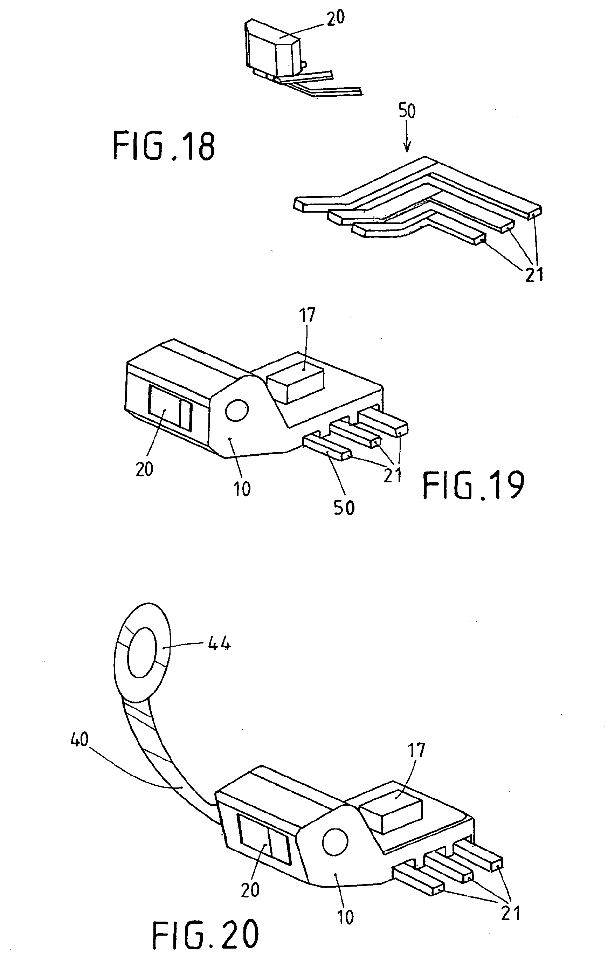

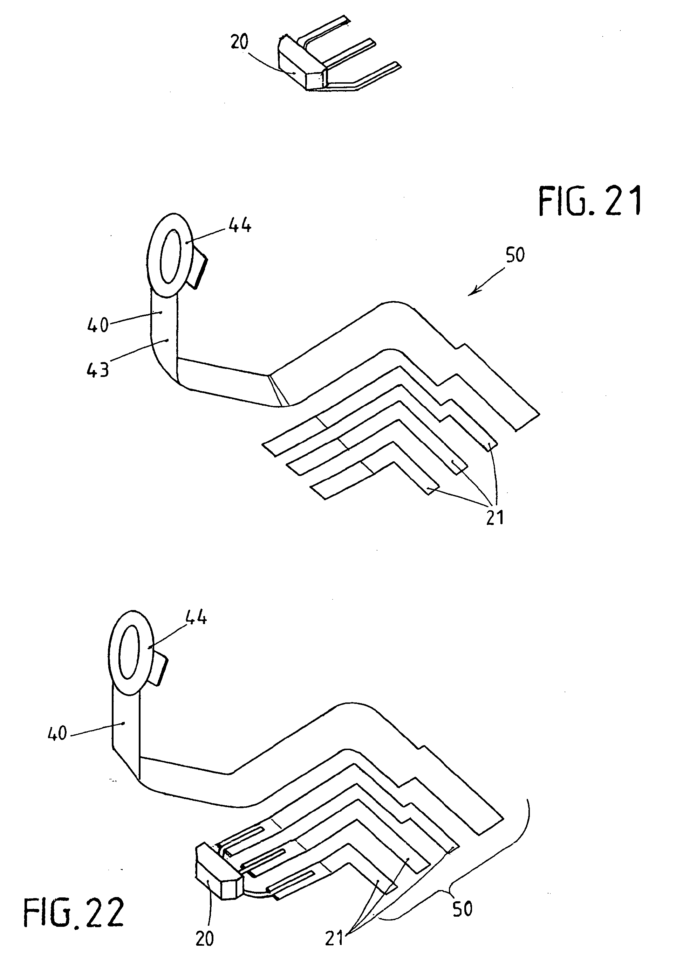

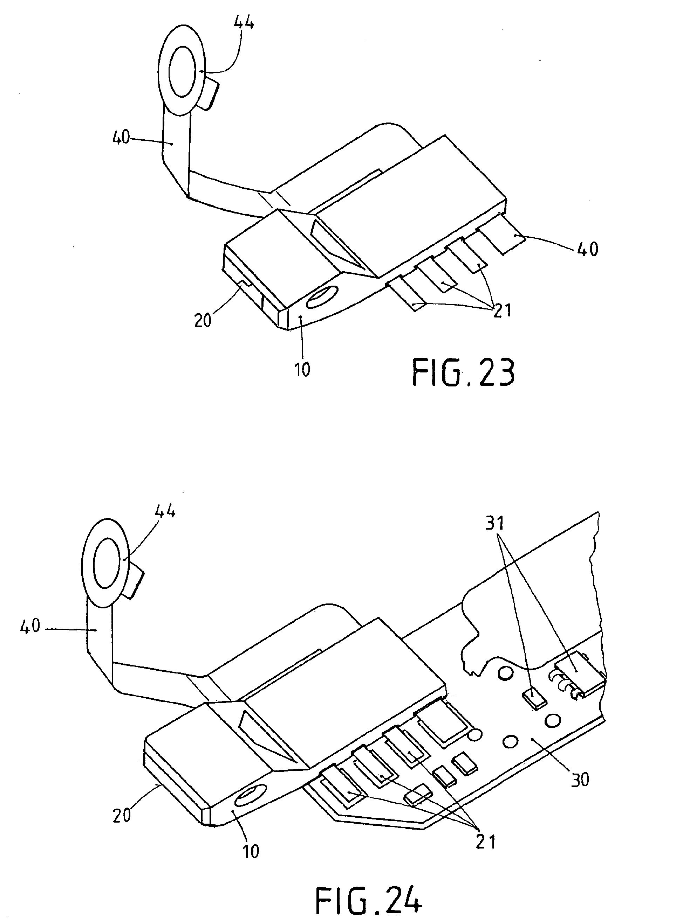

In den Fig. 15 bis 17, 18 bis 20 und 21 bis 24 sind nochmals drei weitere Ausführungsformen der Erfindung dargestellt. Ihnen gemeinsam ist das Vorliegen des Stanzgitters 50, welches unterschiedliche Ausführungen aufweisen kann, und welches die elektrischen Leiter 21 des jeweiligen Hallelementes 20 sowie ggf. auch das Potentialausgleichselement 40, wie in den Fig. 21 bis 24 gezeigt, umfasst. Hierdurch ergibt sich eine möglichst einfache und kostengünstige Herstellung einer Baugruppe bestehend aus Hallelement 20 mit elektrischen Leitern 21, Halter 10 und Potentialausgleichselement 40. Bevorzugt wird zunächst das Hallelement 20 mit dem Stanzgitter 50 verschweißt. Sodann werden diese Bauteile, je nach Ausführungsform mit oder ohne Potentialausgleichselement 40, mit Kunststoff umspritzt, um so den Halter 10 zu formen. Diese fertige Baugruppe kann dann, wie in Fig. 24 gezeigt, auf der Leiterplatte 30 angeordnet werden. Es ist auch möglich, direkt Positionierungsmittel 14 am Halter 10 mit anzuspritzen, um die Kontaktierung mit der Leiterplatte 30 noch zu vereinfachen.

Abschließend sei noch darauf hingewiesen, dass die hier gezeigten Ausführungsformen lediglich beispielhafte Verwirklichungen der Erfindung darstellen. Diese ist nicht darauf beschränkt. Es sind vielmehr noch verschiedene Änderungen und Abwandlungen möglich. Die in der Figurenbeschreibung gezeigten Merkmale können selbstverständlich auch in anderer Kombination verwirklicht werden. Auch das Stanzgitter kann die unterschiedlichsten Formen und Ausmaße annehmen. Der Halter selbst muss ebenfalls nicht die in den Fig. gezeigten Formen besitzen, sondern wird je nach speziellem Anwendungsfall individuell ausgeführt.

### Bezugszeichenliste:

- 10: Halter
- 11: Führung für 21
- 12: Erster Teil von 10
- 13: Zweiter Teil von 10
- 14: Positionierungsmittel
- 15: Leitfähiger Bereich an 10
- 16: Filmscharnier
- 17: Gegenanschlussmittel
- 18: Ausnehmung
- 19: Vorsprung
- 20: Hallelement
- 21: Elektrischer Leiter von 20
- 30: Leiterplatte
- 31: Elektronische Bauteile
- 32: Keil
- 33: erste Aufnahme an 32
- 34: zweite Aufnahme an 32
- 35: Elektrode
- 40: Potentialausgleichselement
- 41: Vorfixierungsmittel
- 42: anderes Ende von 40
- 43: eines Ende von 40
- 44: Öse
- 45: Anschlussmittel
- 50: Stanzgitter

## Patentansprüche

1. Türaußengriff, insbesondere für Fahrzeuge,
mit einer beweglichen Handhabe in Form eines zumindest bereichsweise hohlen Gehäuses, in welchem elektronischen Bauteile (31) aufnehmbar sind,
wobei eine Leiterplatte (30) vorgesehen ist, welche zumindest teilweise zur Aufnahme der elektronischen Bauteile (31) dient,
wobei weiterhin in der Handhabe ein Hallelement (20) vorgesehen ist, welches an einer vordefinierten Stelle in der Handhabe anordnenbar ist,
**dadurch gekennzeichnet,**
**dass** die Leiterplatte (30) starr und plan ausgebildet ist,
**dass** ein separater Halter (10) vorgesehen ist, der das Hallelement (20) trägt und es im Inneren der Handhabe an seiner vordefinierten Position haltert,
wobei diese Position von der Leiterplatte (30) beabstandet ist
und wobei dieser Abstand von dem Halter (10) überwunden wird, der als Verbindungsstück zwischen dem Hallelement (20) und der Leiterplatte (30) fungiert.

2. Türaußengriff nach Anspruch 1, **dadurch gekennzeichnet, dass** ein Potentialausgleichselement (40) für den Potentialausgleich eines metallischen und/oder metallbeschichteten und/oder ansonsten elektrisch leitfähigen Gehäuseelements der Handhabe vorgesehen ist, wobei die Kontaktierung des Potentialausgleichselements (40) über eines seiner Enden (43) erfolgt, vorzugsweise durch eine Öse (44).

3. Türaußengriff nach Anspruch 2, **dadurch gekennzeichnet, dass** das Potentialausgleichselement (40) am Halter (10) anordnenbar ist, insbesondere über ein an seinem anderen Ende (42) vorgesehenes Anschlussmittel (45), welches mit einem am Halter (10) angeordneten Gegenanschlussmittel (17), welche miteinander in Wirkverbindung bringbar sind, und vorzugsweise über den Halter (10) mit der Leiterplatte (30), insbesondere mit dem Massepotential der Leiterplatte (30) verbindbar ist.

4. Türaußengriff nach einem der Ansprüche 1 bis 3, **dadurch gekennzeichnet, dass** das Hallelement (20) und/oder das Potentialausgleichselement (40) am Halter (10) vormontierbar sind und mit diesem eine Baugruppe bilden.

5. Türaußengriff nach einem der Ansprüche 1 bis 4, **dadurch gekennzeichnet, dass** das Hallelement (20) ei en oder mehrere elektrische Leiter (21) aufweist, welche insbesondere durch leitfähige Bereiche (15) des Halters (10), insbesondere aus leitfähigem Kunststoff, gebildet werden können.

6. Türaußengriff nach einem der Ansprüche 1 bis 5, **dadurch gekennzeichnet, dass** der Halter (10) Führungen (11) für die elektrischen Leiter (21) des Hallelements (20) und/oder für das Potentialausgleichselement (40) aufweist.

7. Türaußengriff nach einem der Ansprüche 5 und/oder 6, **dadurch gekennzeichnet, dass** die elektrischen Leiter (21) des Hallelements (20) und/oder das Potentialausgleichselement (40) aus einem Stanzgitter (50) vorgeformt werden, mit welchem das Hallelement (20) verbunden, insbesondere verschweißt wird.

8. Türaußengriff nach einem der Ansprüche 1 bis 7, **dadurch gekennzeichnet, dass** der Halter (10) zweiteilig ausgebildet ist

9. Türaußengriff nach Anspruch 8, **dadurch gekennzeichnet, dass** der erste Teil (12) des Halters (10) zur Aufnahme des Hallelements (20) und/oder des Potentialausgleichselementes (40) dient und durch den ersten (12) und/oder den zweiten Teil (13) die elektrischen Leiter (21) des Hallelements (20) und/oder das Potentialausgleichselement (40) geführt (11) und/oder verformt werden,
wobei die beiden Teile (12, 13) des Halters (10) miteinander verbindbar, insbesondere durch Stecken, Clipsen, Verrastung, Verschweißen, Kleben, Nieten, sind
und wobei insbesondere die beiden Teile (12, 13) miteinander, vorzugsweise durch ein oder mehrere Filmscharniere (16) vorverbunden, sind.

10. Türaußengriff nach einem der Ansprüche 1 bis 9, **dadurch gekennzeichnet, dass** der Halter (10) mit der Leiterplatte (30) in mechanische Wirkverbindung bringbar ist.

11. Türaußengriff nach Anspruch 10, **dadurch gekennzeichnet, dass** die elektrischen Leiter (21) des Hallelements (20) und/oder das Potentialausgleichselement (40) durch das Anordnen des Halters (10) an der Leiterplatte (30) richtig auf der Leiterplatte (30) positioniert werden.

12. Türaußengriff nach einem der Ansprüche 1 bis 11, **dadurch gekennzeichnet, dass** die elektrischen Leiter (21) des Hallelements (20) und/oder das Potentialausgleichselement (40) an der Leiterplatte (30) verlötet wird.

13. Türaußengriff nach einem der Ansprüche 1 bis 12, **dadurch gekennzeichnet, dass** der Halter (10) und/oder das Hallelement (20) und/oder dessen elektrische Leiter (21) und/oder das Potentialausgleichselement (40) Positionierungsmittel (14) und/oder Vorfixierungsmittel (41) aufweisen welche der Positionierung und/oder zur Vorfixierung an der Leiterplatte (30) dienen.

14. Türaußengriff nach einem der Ansprüche 1 bis 13, **dadurch gekennzeichnet, dass** der Halter (10) und/oder das Hallelement (20) und/oder dessen elektrische Leiter (21) und/oder das Potentialausgleichselement (40) mit der Leiterplatte (30) lösbar verbindbar, insbesondere verclipsbar sind.

15. Türaußengriff nach einem der Ansprüche 1 bis 14, **dadurch gekennzeichnet, dass** das Hallelement (20) und/oder dessen elektrische Leiter (21) und/oder das Potentialausgleichselement (40) mit dem Halter (10) lösbar oder unlösbar verbindbar ist, insbesondere durch Verklemmen, Verclipsen, Verklammern, Stecken, Hinterhaken, Verkleben, Verschweißen, Verspritzen oder Vergießen.

16. Türaußengriff nach einem der Ansprüche 1 bis 15, **dadurch gekennzeichnet, dass** das Hallelement (20) und/oder dessen elektrische Leiter (21) und/oder das Potentialausgleichselement (40) und/oder das Stanzgitter (50) zumindest bereichsweise umspritzt werden, wobei die Umspritzung den Halter (10) bildet.

17. Verfahren zur Herstellung von Türaußengriffen, insbesondere für Fahrzeuge, nach einem der Ansprüche 1 bis 16, **dadurch gekennzeichnet, dass** für verschiedene Typen von Türaußengriffen bei denen das Hallelement (20) an unterschiedlichen Stellen angeordnet sein muss, eine standardisierte Leiterplatte (30) verwendet wird und nur der jeweilige Halter (10) in seiner Form und Größe an die Gegebenheiten der entsprechenden Handhabe und der gewünschten Position des Hallelements (20) bei jeder Type von Türaußengriffen angepasst wird.

## Claims

1. External door handle, in particular for vehicles,
with a moveable handle in the form of a housing, which is at least partly hollow, in which electronic components (31) can be accommodated,
whereby, a printed circuit board (30) is provided, which can be partly used to accommodate the electronic components (31),
whereby, furthermore, a Hall element (20) is provided in the handle that can be arranged at a predefined position in the handle,
**characterized in that,**
the printed circuit board (30) is formed rigid and planar,
that a separate holder (10) is provided that supports the Hall element (20) and is supported inside the handle at its predefined position,
whereby, this position is at a distance from the printed circuit board (30)
and, whereby, this distance is negotiated by the holder (10) that functions as a connecting piece between the Hall element (20) and the printed circuit board (30).

2. External door handle according to claim 1, **characterized in that** an equipotential bonding element (40) is provided for the equipotential bonding of a metallic and/or metallic coated and/or other electrical conductive housing element of the handle, whereby, the contact of the equipotential bonding element (40) is carried out at one of the ends (43), preferably though a lug (44).

3. External door handle according to claim 2, **characterized in that** the equipotential bonding element (40) can be arranged on the holder (10), in particular by a connecting element (45) provided at its other end (42), which is connected to a counter-connecting element (17), which can be brought together as an operative connection and is connected, preferably by the holder (10), to the printed circuit board (30), in particular with the earth potential of the printed circuit board (30).

4. External door handle according to one of the claims 1 to 3, **characterized in that** the Hall element (20) and/or the equipotential bonding element (40) is preassembled on the holder (10) and, with this, forms an assembly.

5. External door handle according to one of claims 1 to 4, **characterized in that** the Hall element (20) features one or more electrical conductors (21) which, in particular can be formed through the conductive areas (15) of the holder (10), in particular made from conductive plastic.

6. External door handle according to one of the claims 1 to 5, **characterized in that** the holder (10) features guides (11) for the electrical conductor (21) of the Hall element (20) and/or equipotential bonding element (40).

7. External door handle according to claim 5 and/or 6, **characterized in that** the electrical conductor (21) of the Hall element (20) and/or equipotential bonding element (40) are/is preformed from a pressed screen (50) that is connected to the Hall element (20), in particular is welded.

8. External door handle according to one of the claims 1 to 7, **characterized in that** the holder (10) is formed in two parts.

9. External door handle according to claim 8, **characterized in that** the first part (12) of the holder (10) is used to accept the Hall element (20) and/or the equipotential bonding element (40) and the electrical conductor (21) of the Hall element (20) and/or the equipotential bonding element (40) is guided (11) and/or formed by the first (12) and/or second part (13),
whereby, both parts (12, 13) of the holder (10) are connected to each other, in particular by inserting, clipping, engaging, welding, bonding, riveting
and, whereby, in particular both parts (12, 13) are preconnected to one another, preferably by one or more integral hinges (16).

10. External door handle according to one of the claims 1 to 9, **characterized in that** the holder (10) can be mechanically brought together as an operative connection with the printed circuit board (30).

11. External door handle according to claim 10, **characterized in that** the electrical conductor (21) of the Hall element (20) and/or the equipotential bonding element (40) are/is correctly positioned on the printed circuit board (30) by the arrangement of the holder (10) on the printed circuit board (30).

12. External door handle according to one of the claims 1 to 11, **characterized in that** the electrical conductor (21) of the Hall element (20) and/or the equipotential bonding element (40) are/is soldered onto the printed circuit board (30).

13. External door handle according to one of the claims 1 to 12, **characterized in that** the holder (10) and/or Hall element (20) and/or its electrical conductor (21) and/or the equipotential bonding element (40) features positioning elements (14) and/or preattachment elements (41) that are used for positioning and/or preattaching on the printed circuit board (30).

14. External door handle according to one of the claims 1 to 13, **characterized in that** the holder (10) and/or Hall element (20) and/or its electrical conductor (21) and/or the equipotential bonding element (40) can be connected to the printed circuit board (30) and can be detached, in particular by clipping.

15. External door handle according to one of the claims 1 to 14, **characterized in that** the Hall element (20) and/or its electrical conductor (21) and/or the equipotential bonding element (40) is connected to the holder (10) and can be detached or fixed, in particular by jamming, clipping, clamping, inserting, rear hooks, bonding, welding, spraying or moulding.

16. External door handle according to one of the claims 1 to 15, **characterized in that** the Hall element (20) and/or its electrical conductor (21) and/or the equipotential bonding element (40) and/or the pressed screen (50) are at least partly overmoulded, whereby, the overmoulding forms the holder (10).

17. Method for manufacturing external door handles, in particular for vehicles, according to one of the claims 1 to 16, **characterized in that** the Hall element (20) must be arranged in different positions for the different types of external door handles, a standard printed circuit board (30) is used and only the respective holder (10) is adapted in its shape and size to the circumstances of the corresponding handle and position required of the Hall element (20) for each type of external door handle.

## Revendications

1. Poignée extérieure de portière, notamment pour véhicules automobiles,
comprenant une manette mobile en forme de boîtier au moins localement creux dans lequel il est possible de loger des composants électroniques (31),
sachant qu'est prévue une carte à circuits imprimés (30) servant au moins en partie à recevoir des composants électroniques (31),
sachant en outre qu'est prévu dans la manette un élément à effet Hall (20) qu'il est possible d'agencer dans la manette à un endroit prédéfini,
**caractérisée en ce que**
la carte à circuits imprimés (30) est configurée rigide et plane,
un support (10) séparé est prévu, qui supporte l'élément à effet Hall (20) et le maintient dans une position définie à l'intérieur de la manette,
sachant que cette position se trouve à distance de la carte à circuits imprimés (30)
et sachant que cet écart est franchi par le support (10) qui officie de pièce de liaison entre l'élément à effet Hall (20) et la carte à circuits imprimés (30).

2. Poignée extérieure de portière selon la revendication 1, **caractérisée en ce qu'**est prévu un élément d'équipotentialisation (40) servant à équipotentialiser un élément du boîtier - métallique et/ou à revêtement métallique et/ou sinon autrement électroconducteur - de la manette, sachant que l'entrée en contact de l'élément d'équipotentialisation (40) a lieu via l'une de ses extrémités (43), de préférence à travers un oeillet (44).

3. Poignée extérieure de portière selon la revendication 2, **caractérisée en ce que** l'élément d'équipotentialisation (40) est agençable contre le support (10), notamment via un moyen de raccordement (45) prévu à son autre extrémité (42), moyen qu'il est possible de raccorder à un moyen de raccordement antagoniste (17) agencé contre le support (10) pour les amener tous deux en jonction réciproquement active, et de relier de préférence via le support (10) avec la carte à circuits imprimés (30), en particulier avec le potentiel de masse de la carte à circuits imprimés (30).

4. Poignée extérieure de portière selon les revendications 1 à 3, **caractérisée en ce que** l'élément à effet Hall (20) et/ou l'élément d'équipotentialisation (40) peuvent être prémontés sur le support (10) et qu'ils forment un sous-ensemble avec lui.

5. Poignée extérieure de portière selon l'une des revendications 1 à 4, **caractérisée en ce que** l'élément à effet Hall (20) présente un ou plusieurs conducteurs électriques (21) pouvant être formés notamment par des zones (15) conductrices du support (10), notamment en plastique conducteur.

6. Poignée extérieure de portière selon l'une des revendications 1 à 5, **caractérisée en ce que** le support (10) présente des moyens de guidage (11) pour les conducteurs électriques (21) de l'élément à effet Hall (20) et/ou pour l'élément d'équipotentialisation (40).

7. Poignée extérieure de portière selon l'une des revendications 5 et/ou 6, **caractérisée en ce que** les conducteurs électriques (21) de l'élément à effet Hall (20) et/ou l'élément d'équipotentialisation (40) sont préformés à partir d'une grille matricée (50) avec laquelle l'élément à effet Hall (20) est relié, en particulier soudé.

8. Poignée extérieure de portière selon l'une des revendications 1 à 7, **caractérisée en ce que** le support (10) est configuré en deux parties.

9. Poignée extérieure de portière selon la revendication 8, **caractérisée en ce que** la première partie (12) du support (10) sert à recevoir l'élément à effet Hall (20) et/ou l'élément d'équipotentialisation (40) et **en ce que** les conducteurs électriques (21) de l'élément à effet Hall (20) et/ou l'élément d'équipotentialisation (40) sont guidés à travers (11) et/ou déformés par la première partie (12) et/ou la deuxième (13),
sachant que les deux parties (12, 13) du support (10) sont reliables entre elles, en particulier par enfichage, clipsage, crantage, soudage, collage, rivetage
et sachant qu'en particulier les deux pièces (12, 13) sont reliées d'avance entre elles, de préférence par une ou plusieurs charnières pelliculaires (16).

10. Poignée extérieure de portière selon l'une des revendications 1 à 9, **caractérisée en ce que** le support (10) peut être amené en jonction mécanique opérante avec la carte à circuits imprimés (30).

11. Poignée extérieure de portière selon la revendication 10, **caractérisée en ce que** les conducteurs électriques (21) de l'élément à effet Hall (20) et/ou de l'élément d'équipotentialisation (40) sont positionnés correctement sur la carte à circuits imprimés (30) par agencement du support (10) contre cette même carte (30).

12. Poignée de porte selon l'une des revendications 1 à 11, **caractérisée en ce que** les conducteurs électriques (21) de l'élément à effet Hall (20) et/ou l'élément d'équipotentialisation (40) sur la carte à circuits imprimés (30) sont brasés.

13. Poignée extérieure de portière selon l'une des revendications 1 à 12, **caractérisée en ce que** le support (10) et/ou l'élément à effet Hall (20) et/ou ses conducteurs électriques (21) et/ou l'élément d'équipotentialisation (40) présentent des moyens de positionnement (14) et/ou des moyens de pré-immobilisation (41) qui servent à positionner et/ou à pré-immobiliser sur la carte à circuits imprimés (30).

14. Poignée extérieure de portière selon l'une des revendications 1 à 13, **caractérisée en ce que** le support (10) et/ou l'élément à effet Hall (20) et/ou ses conducteurs électriques (21) et/ou l'élément d'équipotentialisation (40) sont reliables de manière détachable (30) avec la carte à circuits imprimés, dont notamment clipsables.

15. Poignée extérieure de portière selon l'une des revendications 1 à 14, **caractérisée en ce que** l'élément à effet Hall (20) et/ou ses conducteurs électriques (21) et/ou l'élément d'équipotentialisation (40) sont reliables au support (10) de manière détachable ou indétachable, en particulier par bridage, clipsage, agrafage, enfichage, accrochage par l'arrière, collage, soudage, pulvérisation ou noyage.

16. Poignée extérieure de portière selon l'une des revendications 1 à 15, **caractérisée en ce que** l'élément à effet Hall (20) et/ou ses conducteurs électriques (21) et/ou l'élément d'équipotentialisation (40) et/ou la grille matricée (50) sont enrobés au moins localement de matière pulvérisée, sachant que c'est cette matière pulvérisée qui forme le support (10).

17. Procédé pour la fabrication de poignées extérieures de portières, notamment pour véhicules automobiles, selon l'une des revendications 1 à 16, **caractérisé en ce que** l'on utilise, pour différents types de poignées extérieures de portières sur lesquelles il faut que l'élément à effet Hall (20) soit agencé en différents endroits, une carte à circuits imprimés standardisée (30) et que, pour chaque type de poignées extérieures de portières, l'on adapte seulement la forme et la taille du support respectif (10) aux impératifs de la manette correspondante et à la position souhaitée de l'élément à effet Hall (20).
